# EUROPEAN PATENT APPLICATION

(11) **EP 1 642 865 A1**
(43) Date of publication of application: **05.04.2006**
(21) Application number: 04724430.6
(22) Date of filing: 30.03.2004
(51) Int. Cl.: C01B 19/04, C30B 29/66, H01B 13/00, B82B 1/00

(54) **NANO-FIBER OR NANO-TUBE COMPRISING V GROUP TRANSITION METAL DICHALCOGENIDE CRYSTALS, AND METHOD FOR PREPARATION THEREOF**

(30) Priority: 02.06.2003 JP 2003156227
(71) Applicant: Japan Science and Technology Agency, Kawaguchi-shi, Saitama 332-0012 (JP)
(72) Inventor: TANDA, Satoshi 5-20, Higashi Sapporo, Sapporo-shi, Hokkaido 0030002 (JP); INAGAKI, Katsuhiko 1-32-102, Shinkotoni, Sapporo-shi, Hokkaido 0010907 (JP); TSUNETA, Taku, Sapporo-shi, Hokkaido 0630009 (JP); TOSHIMA, Takeshi, Sapporo-shi, Hokkaido 0010023 (JP)
(74) Representative: Wibbelmann, Jobst
(86) International application number: PCT/JP2004/004559
(87) International publication number: WO 2004/108593

(57) **Abstract**

The present invention provides a nanostructure made of V group transition metal dichalcogenide such as NbSe₂ and a method for preparing such a nanostructure. A nanofiber and nanotube comprising crystals of V group transition metal dichalcogenide such as NbSe₂ or TaS₂ have electric properties identical to those of a bulk single crystal.

The preparation method is as follows: high-purity Nb and Se which are starting materials and which are mixed in a stoichiometric ratio are allowed to react with each other at 800°C or less in a vacuum with a temperature gradient of 1 k/cm.

In a method for preparing nanofibers or nanotubes from NbSe₂ that is a starting material by a chemical transport process using a iodine acting as a medium, if C₆₀ acting as a promoter is used, nuclei for forming the nanofibers or the nanotubes can be efficiently produced. Initial nanoparticles surrounding a C₆₀ molecule form nanorings, which grow into the nanotubes. Other nanoparticles surrounding no C₆₀ molecule grow into the nanofibers. The nanofibers prepared as described above have a diameter of 150 nm and a length of 10 µm.

## Description

### Technical Field

The present invention relates to microstructures comprising transition metal chalcogenide crystals. The present invention particularly relates to a microstructure comprising transition metal dichalcogenide crystals and a method for preparing microstructures. The microstructure can be used for various applications such as electromagnetic measuring instruments because of its unique properties.

### Background Art

Transition metal chalcogenides have a common crystal structure and various unique properties such as large electrical, magnetic, and optical anisotropy; hence, the investigation of their properties and the development of their applications have been attracting much attention. In particular, V group transition metal dichalcogenides such as NbSe₂ and TaS₂ have been intensively investigated for applications and properties such as superconductivity and low-dimensional anisotropy.

In particular, in order to determine their properties and in order to develop their applications based on the obtained properties, the dichalcogenides must be processed or formed into structures having such a crystal texture that their properties can be exhibited.

In order to obtain, for example, a superconducting quantum interface device (SQUID) using the superconductivity of transition metal chalcogenide, structures must be prepared so as to have a crystal texture topologically equivalent to that of the chalcogenide.

The inventors have proposed methods for preparing microstructures with a crystal texture equivalent to that of transition metal chalcogenide as disclosed in below Patent Document 1 and Non-patent Documents 1 and 2.

### Known Technical Documents

Patent Document 1: Japanese Unexamined Patent Application Publication No. 2002-255699

Non-patent Document 1: Satoshi TANDA, Taku TSUNETA, Yoshitoshi OKAJIMA, Katsuhiko INAGAKI, Kazuhiko YAMAYA, and Noriyuki HATAKENAKA, "A Mobius strip of single crystals", *Nature,* Nature Japan K. K., vol. 417, no. 6887 (May 23, 2002), pp. 397-398.

Non-patent Document 2: Satoshi TANDA and Taku TSUNETA, "Topological Materials", *Kotai Butsuri,* vol. 37, no. 8 (August 15, 2002), pp. 17-26.

Patent Document 2 discloses a method for preparing a polycrystalline thin-film expected to be applied to solar cells and solid lubricants. This method is a technique for forming a membranous structure made of transition metal chalcogenide.

Patent Document 2: Japanese Unexamined Patent Application Publication No. 7-69782

### Disclosure of Invention

In order to develop applications of transition metal chalcogenide and V group transition metal dichalcogenide such as NbSe₂, nanostructures having a nano-crystal texture and various shapes must be prepared constantly and efficiently.

The present invention provides a nanofiber or nanotube comprising V group transition metal dichalcogenide crystals. In the nanofiber or nanotube, the V group transition metal is Nb or Ta and the chalcogen element is Se or S.

A method for preparing nanofibers or nanotubes comprising V group transition metal dichalcogenide crystals includes a step of producing dichalcogenide by heating a V group transition metal and chalcogen element mixed in a ratio of MX₂ in a vacuum to perform a reaction by a chemical transport process. The reaction is performed for a predetermined time under such non-equilibrium conditions that the maximum temperature is about 800°C, the temperature gradient is 1 to 3 deg/cm, and the difference in temperature due to the temperature gradient is 60 to 100 deg. In the nanofiber- or nanotube-preparing method, the V group transition metal is Nb or Ta and the chalcogen element is Se or S.

Alternatively, nanofibers or nanotubes comprising V group transition metal dichalcogenide crystals are prepared in such a manner that C₆₀ acting as a promoter is used in a step of forming dichalcogenide crystals from powdery V group transition metal dichalcogenide that is a starting material by a chemical transport process using iodine acting as a medium. In the preparation of the nanofibers or nanotubes comprising the V group transition metal dichalcogenide crystals, the V group transition metal is Nb or Ta and the chalcogen element is Se or S.

Transition metal trichalcogenide MX₃ is a material with strong one-dimensionality due to its crystal structure. It has been known that ribbon- or whisker-shaped narrow crystals that are very narrow and fine can be prepared by allowing components thereof to react with each other by a chemical vapor transport process. The inventors have found that when fine NbSe₃ whiskers are formed in such a manner that Se with a low boiling point is repeatedly vaporized and condensed by controlling the atmosphere in a reaction vessel during the formation of such NbSe₃ whiskers by the vapor-phase reaction of Nb with Se and NbSe₃ molecules formed by the reaction are gathered in one place and then crystallized, the NbSe₂ molecules are adsorbed on Se droplets formed in the atmosphere to form loops wound around the droplets acting as templates so that topological crystals with a ring shape, a Mobius strip shape, or an 8-shape are formed. The inventors have reported the finding in Non-patent Documents 1 and 2 described above (Japanese Patent Application No. 2002-340094).

On the other hand, transition metal dichalcogenide MX₂ has a crystal structure in which triangular prism-shaped repeating units identical to those of MX₃ are linked to each other to form a two-dimensional arrangement similar to that of graphite. Its properties such as low-dimensional anisotropy are attracting much attention because of such a structure. In a known chemical transport process, although powdery fine crystals can be prepared depending on the percentage of MX₂ by a vapor-phase reaction, the crystals have hexagonal faces due to its crystal structure.

From the fact that the MX₃ whiskers are formed during the formation of the reported MX₃ topological material, the inventors have conceived that MX₂ nanofibers and MX₂ nanotubes can be prepared by controlling reaction conditions for the formation of MX₂ using MX₃ nanofibers, partly formed in an atmosphere, acting as templates.

That is, features of the present invention are based on the discovery of a phenomenon that MX₃ is converted to MX₂.

When starting materials mixed in a ratio of MX₂ are allowed to react with each other, NbSe₃ is primarily produced due to the temperature gradient in a reaction atmosphere and then converted into NbSe₂ because the temperature at which NbSe₃ is produced is 740°C and is less than the temperature at which NbSe₂ is produced, NbSe₂ being produced at 800°C.

When NbSe₃ is converted into NbSe₂ during the removal of selenium, NbSe₂ nanofibers and nanotubes are formed with nano-sized fibril structures acting as templates.

When MX₂ that is a starting material, iodine, and C₆₀ are subjected to a reaction in such a manner that MX₂, iodine, and C₆₀ are placed in a quartz tube and the quartz tube is evacuated and then sealed, MX₂ is partially converted into MX₃, which is readily vaporizable, at a temperature of 700°C to 720°C during heating, whereby MX₃ nanofibers are primarily formed. In this step, portions of the inner wall of the quartz tube and C₆₀ molecules act as nuclei for growing the nanofibers, that is, C₆₀ acts as a promoter for producing the nanofibers. The C₆₀ molecules act as nuclei for growing MX₃ filaments or nanofibers as disclosed in Japanese Unexamined Patent Application Publication No. 2002-255699. After further heating, MX₃ is converted into MX₂ at a maximum temperature of 780°C to 820°C. In this step, MX₂ nanofibers or nanotubes are formed in a self-assembled manner with the MX₃ nanofibers acting as templates.

NbSe₂ is spherically formed around C₆₀. Initial nanoparticles surrounding each C₆₀ molecule form nanorings, which grow into nanotubes. Other nanoparticles surrounding no C₆₀ molecule grow into nanofibers.

That is, trichalcogenide nanofibers are primarily formed and dichalcogenide nanofibers and/or nanotubes are then formed.

During the removal of selenium, layered NbSe₂ flat structures similar to graphite are curved so as to form tubes, whereby NbSe₂ nanotubes similar to carbon nanotubes are prepared.

### Brief Description of the Drawings

Fig. 1 is a SIM image of a NbSe₂ nanofiber. Fig. 2(A) is a TEM image of bundled NbSe₂ nanotubes prepared from bulk NbSe₂ and Fig. 2(B) is an illustration showing an electron diffraction pattern of a curved NbSe₂ nanotube.
Fig. 3(A) is a TEM image of a NbSe₂ nanofiber and Fig. 3(B) is an illustration showing a TED pattern of another nanofiber with a single hexagonal (hko) plane.
Fig. 4 is a TEM image of a NbSe₂ nanofiber and Fig. 5 is a SEM image of a spiral NbSe₂ nanostructure.

### Best Mode for Carrying Out the Invention

Nanofibers or nanotubes comprising V group transition metal dichalcogenide crystals are nanomaterials prepared by a chemical transport process described below. A typical nanofiber has a diameter of 5 to 500 nm and a length of 1 to 10 µm. A typical nanotube has substantially the same size as described above although the size thereof varies depending on the multi-wall structure thereof.

These nanomaterials have properties identical to those of bulk single crystals of dichalcogenide as described below. Applications utilizing their properties due to their nanostructure have been expected.
(1) Method for directly preparing transition metal dichalcogenide nanofibers or nanotubes by a chemical transport process using starting materials such as a transition metal and a chalcogen element
   High-purity (99.99%) niobium and selenium, which are starting materials, are weighed in a ratio of MX₂. These materials are placed into a quartz ampoule (a length of 20 to 25 cm), heated at a vacuum of 10⁻⁶ Torr, allowed to react with each other at a maximum temperature of 820°C for 72 hours with a temperature gradient of 1 to 3 deg/cm, and then cooled to room temperature, whereby nanomaterials are obtained.
   If the reaction time is short, for example, less than one hour, nanofibers or nanotubes can be produced. The reaction is continued for three days at the maximum such that the yield of the nanotubes is increased, though the number of walls of the nanotubes varies depending on the reaction time. The nanotubes prepared in this manner are multi-walled and thick.
(2) Method for preparing transition metal dichalcogenide nanofibers or nanotubes using powdery transition metal dichalcogenide crystal, which is a starting material, and C₆₀ acting as a promoter

Powdery 99.99% NbSe₂, which is a starting material, C₆₀, and iodine are placed into a quartz tube. The tube is sealed, evacuated, and then heated.

As well known, the following chemical equilibrium holds in the reaction tube:

MX₂ + I₂ ↔ MI₂ + 2X

During heating, at 700°C to 720°C, NbSe₂ is partially converted into NbSe₃, which is readily vaporizable, whereby crystals are grown with C₆₀ molecules, vaporized at 340°C, acting as growth promoters. NbSe₃ nanostructures are grown with the C₆₀ molecules acting as nuclei and then converted into NbSe₂ nanostructures at a maximum temperature of about 820°C.

These reaction conditions are substantially the same as those of the above method for directly preparing the transition metal dichalcogenide nanotubes from those starting materials by the chemical transport process.

In the reaction tube, MX₂, that is, the NbSe₂ nanomaterials are crystallized on low-temperature regions of the quartz ampoule with the above temperature gradient because MI₂ is more volatile than MX₂.

The NbSe₂ nanomaterials obtained are suspended in dichloroethane or isopropyl alcohol and nanoparticles are separated by precipitation.

The nanomaterials can be more properly prepared by this method as compared to that method using the direct reaction.

The nanomaterials prepared by these methods were observed with a scanning electron microscope (SEM), a field emission-transmission electron microscope (FE-TEM), or a scanning ion microscope (SIM) and the structure thereof was investigated as described below.

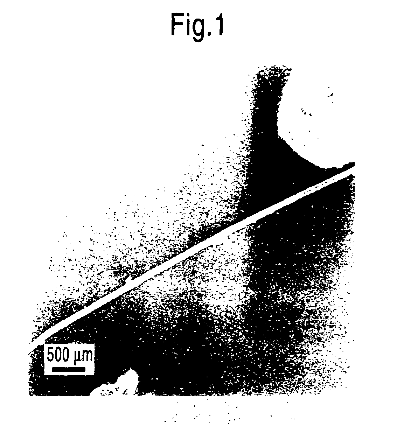

A transition metal dichalcogenide fiber with a nanoscale extends along a normal NbSe₂ crystal with a hexagonal face. Fig. 1 is a SIM image of such an example.

A linear material located at the center of the image is a typical NbSe₂ nanofiber having a width of 15 nm and a length of 1 µm. Fine particles that are in contact with the nanotube and a large polygonal plate located in the upper right corner of the image are typical NbSe₂ crystals.

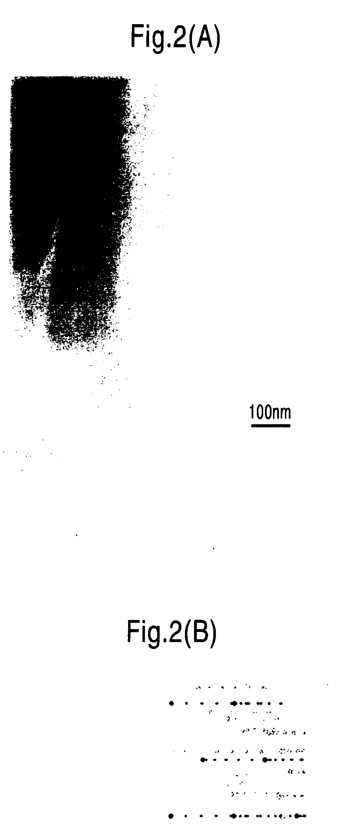

Fig. 2(A) is a SIM image of multi-walled NbSe₂ nanotubes (multi-wall). The NbSe₂ nanotubes are bundled and have a diameter of 20 to 40 nm. With reference to the interplanar spacing described below, the diameter difference corresponds to about 30 crystalline walls. The diameter difference probably depends on the reaction time; hence, when thin nanotubes are prepared, the reaction time must be short. However, a reduction in reaction time reduces the yield of such nanotubes.

Fig. 2 (B) is a TEM image of a curved nanotube, present in the bundle, having a diameter of about 50 nm. The presence of three sets of diffraction spots in a diffraction pattern suggests a cylindrical structure.

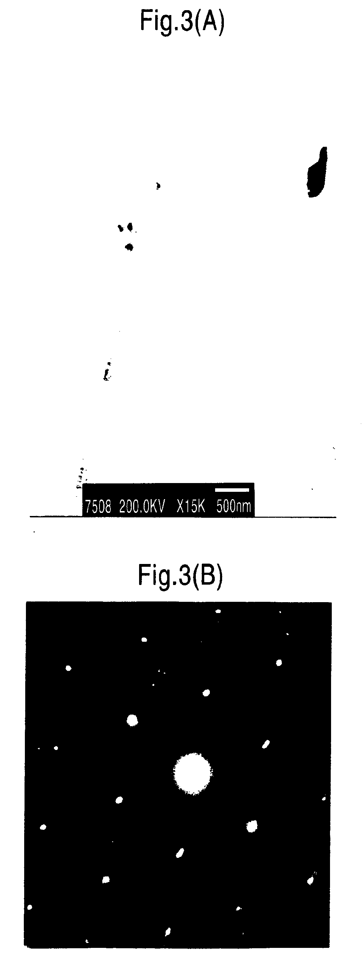

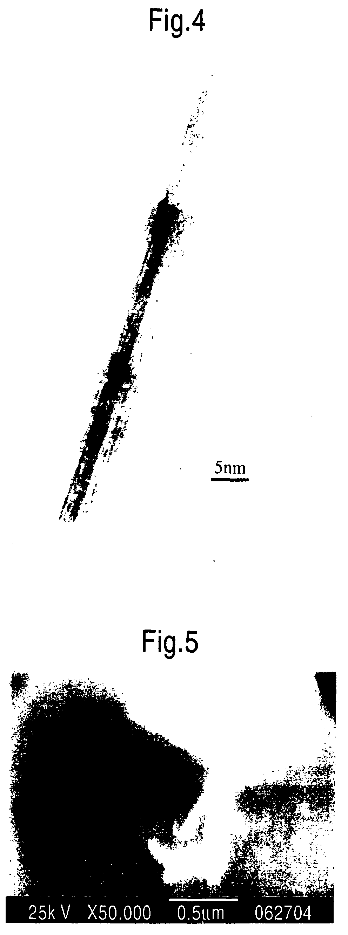

Fig. 3(A) is a TEM image of a NbSe₂ nanofiber, which has a single hexagonal (hko) lattice as shown in Fig. 3(B). Fig. 4 shows this type of nanofiber. This nanofiber has a (001) plane. The interplanar spacing thereof is 6.37 Å and is substantially equal to that of bulk 2H-NbSe₂, which has an interplanar spacing of 6.25 Å. A line shown in this figure indicates the (001) plane of NbSe₂. This sample contains C₆₀ for promoting the growth of crystals.

In the preparation method using C₆₀ for promoting the formation of the nanofibers/nanotubes, when C₆₀ is present in a reaction step of forming crystals by the chemical transport process using iodine and NbSe₂ prepared in advance, C₆₀ acts to form nuclei for forming the nanofibers or the nanotubes, that is, C₆₀ acts as a growth promoter for promoting the formation of the nanofibers or the nanotubes.

Nanoparticles which have such nuclei and which surround each C₆₀ molecule form nanorings, which grow into the nanotubes. However, if wrapping does not occur, the nanofibers grow.

Since C₆₀ is sublimated at 340°C or more, the formation of the nuclei in the presence of C₆₀ occurs not only on the inner wall of the quartz ampoule but also in the entire inside of the ampoule.

Since the reaction of NbSe₂ proceeds in the presence of a large number of the nuclei, NbSe₂ nanostructures formed as a result of the competition are fine. Fluctuation in a vapor phase reaction allows formed crystals to have a spiral structure. Fig. 5 is a SEM image of a nanofiber prepared using C₆₀. With reference to this figure, this nanofiber is spiral-shaped and has a width of about 6 nm and a length of about 1 µm.

As described above, it has been confirmed that C₆₀ plays a critical role in the growth of the NbSe₂ nanostructures and the preparation efficiency and yield thereof can be enhanced by the use of C₆₀.

Properties of nanomaterials prepared by these methods were investigated. A NbSe₂ nanofiber was attached to an electrode by a focus ion beam technique and then measured for electrical properties. The electrical resistance in a crystal plane was 7 x 10⁻⁵ Ω·cm.

Measurement was performed in such a manner that the tip of an atomic force microscope (AFM) was used an electrode and directly placed on a sample. A conductive probe was a silicon single crystal coated with platinum.

NbSe₂ fibers were ultrasonically mixed in isopropyl alcohol and then deposited on an indium film with a thickness of 200 nm.

The efficiency of this system was tested using a multi-walled carbon nanotube and it was confirmed that the electrical resistance thereof agreed with values disclosed in ordinary scientific documents.

In order to perforate the outermost insulating wall, a load of 200 nN was applied to the tip of the AFM, whereby a current of 5 x 10⁻⁹ A was allowed to flow with a bias voltage of 1 x 10⁻³ V. That is, the resistance is about 200 kΩ and the resistivity is roughly estimated to be in the range of 10⁻³ to 10⁻² Ω·m. This value is close to the resistivity perpendicular to the c axis, that is, 4 x 10⁻⁵ Ω·m.

Electrical properties of these nanomaterials are substantially the same as those of bulk crystals, that is, the properties thereof are maintained. NbSe₂ exhibits superconductivity at 5 K and a CDW transition at 30 K. TaSe₂ exhibits a CDW transition at room temperature (300 K).

In the above description, Nb which is a V group transition metal and Se which is a chalcogen element are used; however, a V group transition metal and chalcogen element used herein are not limited to these elements. From properties common to these elements, it is clear that nanofibers or nanotubes can be theoretically prepared from another V group transition metal and another chalcogen element by the same method as described above. In particular, TaS₂ consisting of Ta which is a V group transition metal and S which is a chalcogen element is useful in preparing nanomaterial identical to those described above under substantially the same conditions as described above.

### Industrial Applicability

The present invention provides a nanofiber and nanotube made of V group transition metal dichalcogenide, for example, Nb or Ta dichalcogenide and also provides an efficient preparation method thereof. This enables the investigation of unknown characteristics of a group of these materials having specific properties and also enables the development of applications of these materials.

Any nanomaterial provided by the present invention is essential to advances in techniques using properties thereof because the nanomaterial has a topological structure for exhibiting its properties; hence, the nanomaterial contributes to the progress of industry.

## Claims

1. A nanofiber or nanotube comprising V group transition metal dichalcogenide crystals.

2. The nanofiber or nanotube according to Claim 1, wherein the V group transition metal is Nb or Ta and the chalcogen element is Se or S.

3. A method for preparing nanofibers or nanotubes comprising V group transition metal dichalcogenide crystals, the method comprising a step of producing dichalcogenide by heating a V group transition metal and chalcogen element mixed in a ratio of MX₂ in a vacuum to perform a reaction by a chemical transport process, wherein the reaction is performed for a predetermined time under such non-equilibrium conditions that the maximum temperature is about 800°C, the temperature gradient is 1 to 3 deg/cm, and the difference in temperature due to the temperature gradient is 60 to 100 deg.

4. The nanofiber- or nanotube-preparing method according to Claim 3, wherein the V group transition metal is Nb or Ta and the chalcogen element is Se or S.

5. A method for preparing nanofibers or nanotubes comprising V group transition metal dichalcogenide crystals, the method comprising a step of forming dichalcogenide crystals from powdery V group transition metal dichalcogenide that is a starting material by a chemical transport process using iodine acting as a medium, wherein the forming step includes a sub-step of adding C₆₀ acting as a promoter.

6. The nanofiber- or nanotube-preparing method according to Claim 5, wherein the V group transition metal is Nb or Ta and the chalcogen element is Se or S.
